# FASCICULE DE BREVET EUROPEEN

(11) **EP 2 797 193 B1**
(45) Date de publication et mention de la délivrance du brevet: **13.03.2019**
(21) Numéro de dépôt: 14165639.7
(22) Date de dépôt: 23.04.2014
(51) Int. Cl.: H02G 11/02, G01R 31/02

(54) **Contrôleur de continuité**
Durchgangsprüfer
Continuity controller

(30) Priorité: 23.04.2013 FR 1353713
(43) Date de publication de la demande: 29.10.2014
(73) Titulaire: Electro P.J.P., 39100 Dole (FR)
(72) Inventeur: Marotte, M. Philippe, 25440 QUINGEY (FR)
(74) Mandataire: Regimbeau

(56) Documents cités:
- WO-A1-02/10781
- DE-U1- 20 312 254
- FR-A1- 2 845 481
- GB-A- 2 449 285

## Description

La présente invention concerne les contrôleurs pour le contrôle de la continuité de conducteurs de protection et de liaisons équipotentielles.

Le contrôleur proposé est notamment particulièrement adapté pour des contrôles par des professionnels du diagnostic immobilier (diagnostiqueurs immobiliers, organismes de contrôle par exemple).

Il est également destiné à d'autres et notamment aux professionnels de l'électricité.

### DOMAINE DE L'INVENTION ET ETAT DE LA TECHNIQUE

Les professionnels électriciens utilisent classiquement, pour contrôler des installations électriques, des contrôleurs de mise à la terre qui permettent d'une part de vérifier si les prises testées sont bien raccordées à la terre et d'autre part d'effectuer des mesures de résistance.

On connait notamment des contrôleurs de ce type qui se présentent sous la forme d'un boitier à écran d'affichage, qui intègre une électronique de mesure. Ce boitier se termine d'un côté par une connectique de prise électrique et de l'autre par une connectique qui permet de lui raccorder un câble qui se termine lui-même par une fiche ou une pince crocodile destinée à être rapportée sur une référence de terre. Le câble est par exemple associé à un enrouleur.

Avec un tel dispositif, l'opérateur se déplace de prise en prise en ayant en permanence les deux mains occupées. L'une manipule le boitier, tandis que l'autre déplace le câble et son enrouleur.

Une telle configuration est donc encombrante pour l'utilisateur et est par exemple peu adaptée à des contrôles par des professionnels qui voudraient se déplacer sur les différentes installations pour les contrôler tout en notant sur une feuille ou une tablette les résultats de leurs différents contrôles.

On notera par ailleurs que les dispositifs de contrôle de continuité connus dans l'art antérieur sont souvent multifonctions, ce qui contribue à leur encombrement et les rend peu facile à utiliser pour utilisateurs qui ne seraient pas des professionnels électriciens.

Le document WO 02/10781 décrit un dispositif pour surveiller la résistance électrique comportant un boîtier dans lequel est logé un circuit imprimé et une diode électroluminescente ménagée de sorte à être visible pour un utilisateur. Le boîtier est relié électriquement à un câble se terminant par une pince de mise à terre. Le dispositif décrit dans ce document comprend également un tambour d'enroulement pour enrouler le câble.

### EXPOSE DE L'INVENTION

Un but de l'invention est de proposer un contrôleur de continuité qui est facile à manipuler et qui permet à l'utilisateur une plus grande liberté de mouvement.

Un autre but de l'invention est de proposer un contrôleur de continuité qui est à la fois simple, performant et d'un coût réduit et peut être utilisé, en particulier, pour le diagnostic immobilier sur l'ensemble d'un bâtiment ou logement.

Le contrôleur selon l'invention est défini dans la revendication 1.

Le
contrôleur proposé comporte un boitier d'électronique de test qui est relié ou est apte à être relié électriquement à un câble se terminant par un contact apte à être connecté à une référence de tension (référence de terre par exemple). Ledit boitier comprend une façade d'interface pour sa commande et l'information de l'utilisateur.

Ce contrôleur comporte un dérouleur pour ledit câble, le boitier de l'électronique de test et l'enrouleur étant rapportés l'un sur l'autre, l'enrouleur étant monté rotatif sur ledit boitier. L'électronique de test comporte au moins une connectique pour la connexion d'un cordon testeur.

Avec une telle configuration, l'utilisateur peut saisir d'une main l'ensemble boitier/dérouleur pour les déplacer d'une installation à tester à une autre tout en ayant son autre main libre pour porter par exemple une tablette ou des feuilles sur lesquelles il note les résultats de ses mesures.

Elle permet donc des contrôles simples et est particulièrement adaptée à des contrôles d'installations électriques par d'autres que des électriciens professionnels et notamment par des diagnostiqueurs immobiliers ou des organismes de contrôle.

Il répond au besoin de diagnostiqueur d'avoir un appareil monofonctionnel à prix inférieur au prix d'appareil multifonction comprenant la fonction de contrôle de la continuité de conducteurs de protection et de liaisons équipotentielles d'installations électriques.

Un tel contrôleur est en outre avantageusement complété par les différentes caractéristiques suivantes prises seules ou en combinaison :
- l'enrouleur comporte une connectique à contact tournant apte à raccorder ledit câble dudit enrouleur et un contact axial fixe par rapport au boitier .
- ladite connectique à contact tournant est un connecteur à fiches bananes à lamelles ressort /.
- ledit boitier comporte au moins un guide pour sa fixation orientée à la ceinture d'un utilisateur ;
- les formes du boitier sont galbées et sans angle ;
- le boitier comprend au moins une autre connectique pour contrôler la continuité sur un appareil déconnecté du réseau ;
- ledit boitier d'électronique de test comprend un pont en H pour assurer l'inversion automatique de polarité desdites connectiques ;
- ledit boitier comprend un système de compensation de la résistance du câble et des résistances de la carte.

L'invention propose également un ensemble de test pour le contrôle de continuité de conducteurs de protection et de liaisons équipotentielles d'installations électriques, caractérisé en ce qu'il comporte :
- un dispositif de test selon l'une des revendications précédentes,
- un câble se terminant par un contact apte à être connecté à une référence de terre du bâtiment ou logement, ledit câble étant raccordé au dispositif de test et étant enroulé sur l'enrouleur de celui-ci ou destiné à l'être,
- un cordon testeur qui est adapté pour être rapporté sur la connectique de l'électronique de test.

Un tel ensemble de test est par exemple utilisé pour le diagnostic d'un bâtiment ou d'un logement.

### DESCRIPTION DES FIGURES

- La figure 1 est une représentation schématique en perspective illustrant un exemple de réalisation d'un contrôleur selon l'invention ;
- La figure 2 est un schéma illustrant le circuit de protection entre les trois entrées du contrôleur ;
- La figure 3 une représentation schématique en vue en perspective éclatée du contrôleur de la figure 1 ;
- La figure 4 illustre un contact tournant d'un contrôleur conforme à un mode de réalisation possible pour le contrôleur de la figure 1 ;
- La figure 5 représente, en perspective éclatée une configuration possible pour un boitier d'électronique de test de contrôleur.
- La figure 6 représente, un schéma électrique de contrôleur conforme à un mode de réalisation de l'invention.

### DESCRIPTION DETAILLEE DE L'INVENTION

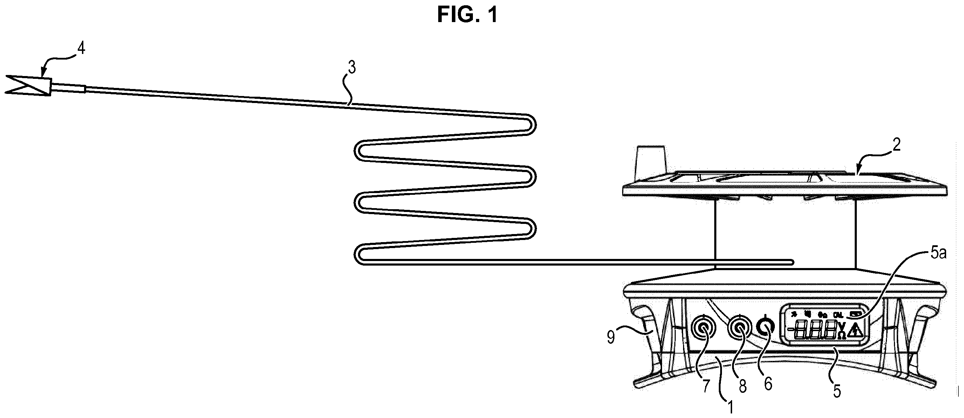

En référence à la figure 1, le contrôleur qui est représenté comporte :
- un boitier d'électronique de test 1,
- un dérouleur 2 qui est rapporté sur ledit boitier 1 et est monté rotatif sur celui-ci,
- ainsi qu'un câble 3 enroulé sur le dérouleur 2 et qui se termine par un contact 4, par exemple une pince crocodile, qui permet de connecter ledit boitier 1 à une référence de tension (référence de terre, par exemple) éloignée dudit boitier 1.

Le boitier 1 présente une façade d'interface 5 qui comprend un afficheur LCD 5a permettant à l'utilisateur de consulter les informations de mesure, un ou plusieurs boutons de commande 6, ainsi que des éléments de connectique 7 et 8 lui permettant de connecter des cordons de test.

Il présente également, du côté opposé au dérouleur 2 et de part et d'autre de l'afficheur 5a, des anses ou boucles 9 qui constituent un guide qui permet de passer une ceinture d'utilisateur.

De cette façon, l'utilisateur peut porter le boitier 1 et le dérouleur 2 à la ceinture. L'ensemble est alors orienté : l'utilisateur visualise directement l'afficheur 5a ; il branche et débranche facilement les cordons de test sur les éléments de connectique 7 et 8. Ainsi, il peut se déplacer d'une prise ou d'une installation à tester à une autre en laissant le câble 3 se dérouler et en ayant les mains relativement libres. Il dispose par conséquent d'une grande liberté de mouvement lors des opérations de contrôle de continuité.

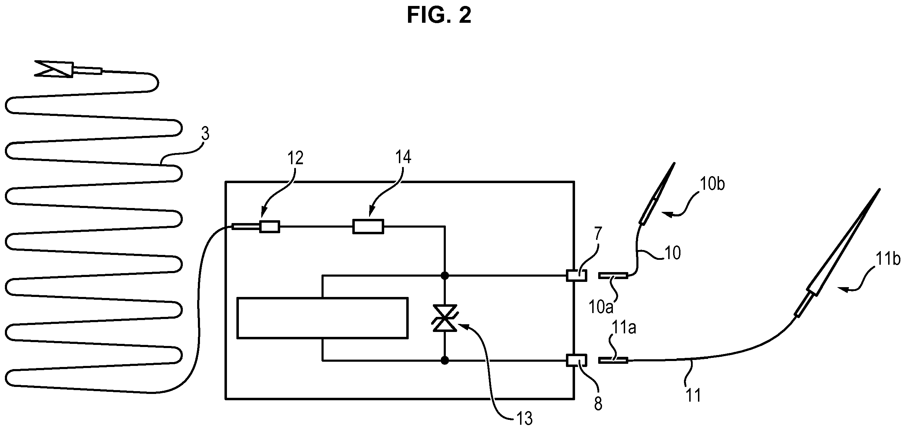

Plus précisément, ainsi qu'illustré sur la figure 2, les éléments de connectique 7 et 8 sont des douilles banane de, par exemple, 4mm - situées en façade du boitier. Elles coopèrent avec des fiches mâles 10a, 11a de cordons testeurs 10, 11 qui se terminent par des pointes ou perchettes de contact 10b, 11b.

La connectique de raccordement au câble 3 comporte quant à elle un contact tournant 12, qui accompagne la rotation du dérouleur 2 en même temps que le contact électrique avec le câble 3.

La mesure de continuité est réalisée entre les connectiques 8 et 12. Elle peut également être réalisée entre les connectiques 7 et 8 en utilisant à cet effet les deux cordons testeurs 10 et 11. De cette façon, l'utilisateur peut réaliser des contrôles de continuité non seulement entre une installation et une référence à distance, mais également d'effectuer des tests directement sur des appareils déconnectés du réseau, par exemple, lave-linge, cafetière, machine-outil, etc. Ceci permet alors de s'assurer de la continuité et de la valeur de la résistance entre la borne de terre située sur la prise électrique de l'appareil à contrôler et la carcasse de ledit appareil.

Une diode Transil 13 (TVS - Transient Voltage Suppressor) est prévue pour absorber les surtensions transitoires présentes sur le réseau, tandis que le circuit de mesure comporte, entre les connectiques 7 et 12, un fusible 14, par exemple un fusible rapide 500V / 500mA, qui est utilisé pour couper la connexion entre lesdits douilles si l'utilisateur fait une mauvaise manipulation. Son but est d'éviter de faire disjoncter l'installation électrique complète.

Il est préférable que ladite diode 13 soit bidirectionnelle et que sa tension de blocage soit supérieure à la tension nominale de service (soit au moins 480Vrms). En défaut, cette diode se met en court-circuit ce qui permet de protéger le reste de l'électronique en utilisant le fusible 14 en amont.

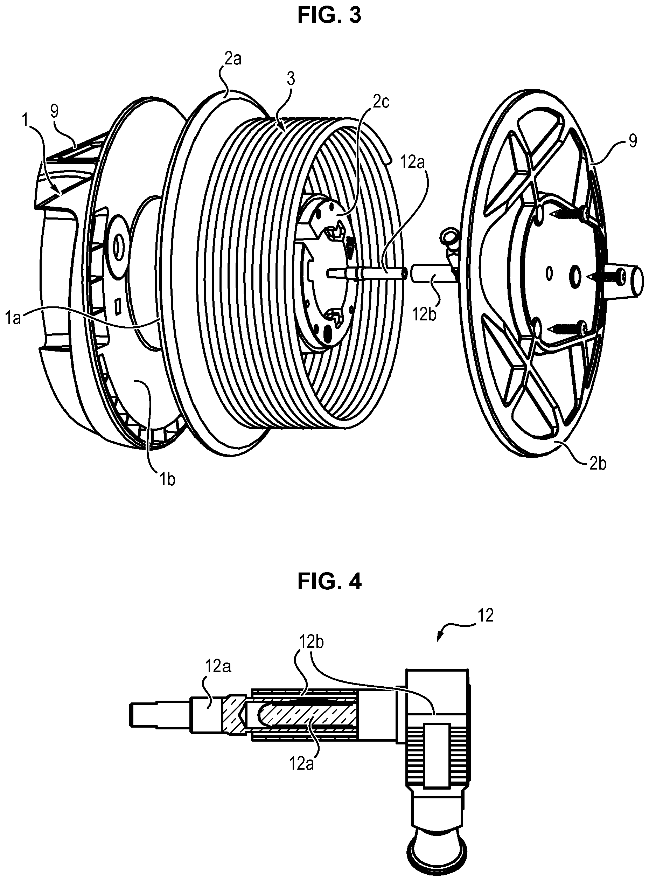

Ainsi que le montrent les figures 3 à 5, le dérouleur 2 comporte un flasque intérieur 2a, un flasque extérieur 2b et un moyeu 2c qui s'étend à partir du flasque intérieur et sur lequel le flasque extérieur 2b est fixé par des vis. Le câble 3 est bobiné sur le moyeu 2c.

Le moyeu 2c est lui-même emboité à rotation sur un axe 1a qui s'étend à partir du fond 1b du boitier 1 et qui assure avec ledit moyeu 2c la rotation du dérouleur 2 par rapport au boitier 1

Le contact 12 est plus particulièrement représenté sur la figure 4 et est quant à lui constitué d'un contact fixe 12a qui s'étend axialement à partir du boîtier 1, à l'intérieur du moyeu 2c, ainsi que d'un contact tournant 12b à ressort à lamelles de contact qui est monté en L sur le flasque extérieur 2b et qui s'enfiche sur le contact fixe 12a.

Avec une telle configuration, le groupe rigide constitué du boîtier 1 et du contact fixe 12a peut rester fixe à la ceinture de l'utilisateur, tandis que le dérouleur 2 et la partie formant contact tournant 12b constituent un groupe tournant par rapport à ce premier groupe rigide, la liaison électrique se faisant par l'intermédiaire du ressort à lamelle de contact.

On notera ici que la fixation du flasque extérieur 2b avec des vis facilite le remplacement de la bobine de câble 3, notamment dans le cas où celle-ci serait pour un raison ou une autre hors d'usage.

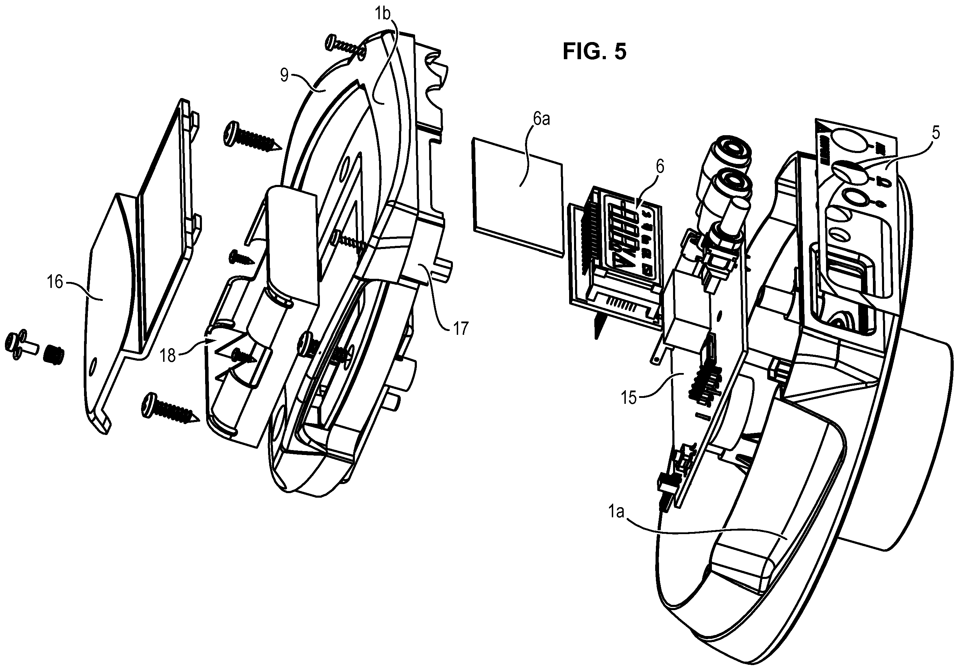

La structure du boîtier 1 est plus particulièrement détaillée à la figure 5.

Ledit boîtier 1 comporte d'une part une partie 1a fixe d'où s'étend un axe de rotation et qui définit l'essentiel de la façade d'interface 5.

Une carte mère de mesure 15 est placée dans cette partie 1a principale du boitier 1 dont la façade 5 reçoit le module LCD 6 et sa vitre de protection 6a.

Le boîtier 1 comporte également une partie fond 1b qui se referme sur la partie 1a et qui porte les anses ou boucles 9, lesquelles définissent ensemble le guide de ceinture.

Cette partie 1b comporte elle-même une trappe 16 qui ferme un logement 17 pour un boîtier de piles 18.

Par ailleurs, les formes du boitier 1 sont galbées et sans angle, ce qui évite tout risque de blessure pour l'utilisateur.

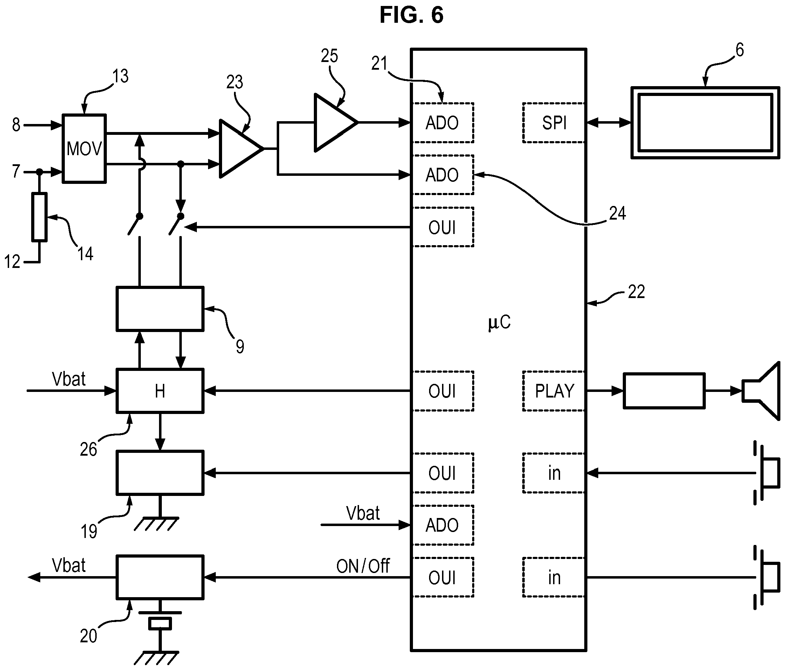

Le circuit de mesure du contrôleur illustré sur la figure 6 comporte un circuit de mesure de tension différentielle. Le circuit de mesure du contrôleur comporte en outre un générateur de courant constant 19. La gestion d'alimentation d'éléments dudit circuit est pilotée par un module de gestion d'alimentation 20. La mesure différentielle de tension entre les bornes du contrôleur est activée en permanence. Elle permet d'une part de déterminer la valeur de la résistance et d'autre part de vérifier l'absence de tension dangereuse. L'acquisition de mesures est réalisée par un convertisseur analogique numérique interne 21 du microcontrôleur 22.

Une fois les douilles connectées une mesure de la tension aux bornes des douilles 7-8 ou 8-12 est lancée. Si le microcontrôleur 22 ne détecte pas de tension auxdites bornes il envoie un signal d'activation sur le générateur de courant 19 (210mA) pour l'activer.
Si une tension sinusoïdale de fréquence 50Hz ou 60Hz d'amplitude max. +/-5V est présente aux bornes des douilles, la mesure de la résistance est encore possible. Si la tension en entrée est supérieure à +/-5V, le contrôleur avertit l'utilisateur d'une présence de la tension dangereuse par un bip intermittent.

La mesure de continuité est réalisée soit entre les bornes 7 et 8, soit entre les bornes 8 et 12. La mesure entre les bornes 7 et 8 est utilisée pour vérifier la continuité de potentiel entre différents points métalliques d'un circuit non relié au réseau. La mesure entre les bornes 8 et 12 permet de vérifier la continuité du circuit de Terre entre le tableau électrique du bâtiment et les différents points métalliques accessible qui doivent être reliés. Une diode Transil 13 (TVS - Transient Voltage Suppressor) est installée entre les douilles 7 et 8 pour absorber les surtensions transitoires présentes sur le réseau. En défaut, ladite diode 13 se met en court-circuit ce qui permet de protéger le reste de l'électronique. Entre les douilles 7 et 12, un fusible est utilisé pour éviter de faire disjoncter le bâtiment si l'utilisateur fait une mauvaise manipulation.

Les signaux provenant des bornes 7-8 ou 8-12 sont envoyés sur un amplificateur opérationnel 23. La tension à la sortie dudit amplificateur 23 est récupérée directement par un convertisseur analogique numérique interne 24 du microcontrôleur 22 pour mesurer la tension. Ledit signal arrive également sur un autre convertisseur analogique numérique interne 21 du microcontrôleur 22 moyennant un amplificateur 25 pour mesurer la résistance. Le contrôleur mesure la tension différentielle aux bornes choisis précédemment sur 100ms puis sauvegarde la valeur de cette mesure dans la mémoire interne du microcontrôleur 22.

Pour respecter la norme 61557-4, le générateur de courant comporte un circuit d'inversion de polarité permettant d'effectuer une mesure alternative. Pour faire cela le sens de circulation du courant est commuté à la fréquence de 5Hz (soit un changement de polarité toutes les 100ms) à l'aide d'un pont en H 26 piloté par ledit microcontrôleur 22. Le pont en H est une structure électronique classiquement connue servant à contrôler la polarité aux bornes d'un dipôle. Il est composé de quatre éléments de commutation généralement disposés schématiquement en une forme de H. Les commutateurs peuvent être des relais, des transistors, ou autres éléments de commutation en fonction de l'application visée.

Une fois la mesure sur 100ms prise ledit microcontrôleur 22 envoie automatiquement un signal de commutation de douilles sur ledit pont en H 26 qui change le sens de circulation du courant. Une autre mesure sur 100ms de la tension différentielle aux bornes précédemment choisies est faite. Ledit microcontrôleur 22 effectue une comparaison de cette valeur avec la valeur mesurée précédemment. Si lesdites valeurs sont identiques la mesure est validée par ledit microcontrôleur 22 et puis la résistance est calculée en prenant en compte les valeurs d'offset et de gain que le système a calibré. Ledit microcontrôleur 22 affiche la valeur sur un écran à diodes électroluminescentes 6 (type LCD par Exemple). Si la valeur mesurée de la résistance est inférieure à 2ohms la couleur bleu est affichée sur ledit écran 6 et un signal sonore est produit par l'intermédiaire du microcontrôleur 22. Si la valeur mesurée de la résistance est supérieure à 2ohms la couleur rouge est affichée. La mesure se répète tant que les douilles sont connectées.

Pour augmenter la rapidité du système la toute première mesure est réalisée avec un temps plus court, 5ms au lieu de 100ms. De plus, si la mesure de la résistance est supérieure à 2.5ohm, le microcontrôleur diminue automatiquement le courant de génération à 25mA pour permettre de mesurer des résistances jusqu'à 20ohms.
Le contrôleur est équipé d'un système de compensation de la résistance du câble et des résistances de la carte. A cet effet, l'électronique offre la possibilité de tarer à zéro ses résistances électriques propres et celles des accessoires connectés tels que les cordons, les perches, les pinces crocodiles, etc. Quand la compensation est réalisée, la lecture de la résistance mesurée est directe, la résistance lue correspond à la résistance totale mesurée moins les résistances de l'électronique et des accessoires.

Le contrôleur peut être avantageusement équipé d'un système sonore indiquant si la mesure est correcte par rapport à une valeur étalon figée en usine de, par exemple, 2 Ohm, d'un afficheur bicolore fonction des valeurs mesurées conformes ou pas, d'un système de détection indiquant la présence de tension dangereuse.

## Revendications

1. Contrôleur de continuité de conducteurs de protection et de liaisons équipotentielles d'installations électriques, comportant un boitier (1) d'électronique de test comprenant une électronique de test, ledit boîtier étant apte à être relié électriquement à un câble (3) se terminant par un contact (4) apte à être connecté à une référence de tension, ledit boitier comprenant une façade d'interface (5) pour sa commande et l'information de l'utilisateur, ledit contrôleur comportant un dérouleur (2) pour ledit câble,
**caractérisé en ce que** le boitier de l'électronique de test et le dérouleur sont rapportés l'un sur l'autre, le dérouleur étant monté rotatif sur ledit boitier et
**en ce que** l'électronique de test comporte au moins une connectique (7, 8) pour la connexion d'un cordon testeur (10, 11).

2. Contrôleur de continuité de conducteurs de protection et de liaisons équipotentielles d'installations électriques selon la revendication 1 **caractérisé en ce que** le dérouleur (2) comporte une connectique à contact tournant (12) apte à raccorder ledit câble dudit dérouleur et un contact axial fixe par rapport au boitier (1).

3. Contrôleur de continuité de conducteurs de protection et de liaisons équipotentielles d'installations électriques selon la revendication 2, **caractérisé en ce que** ladite connectique à contact tournant est un connecteur à fiches bananes à lamelles ressort

4. Contrôleur de continuité de conducteurs de protection et de liaisons équipotentielles d'installations électriques selon l'une des revendications 1 à 3, **caractérisé en ce que** ledit boitier (1) comporte au moins un guide (9) pour sa fixation orientée à la ceinture d'un utilisateur.

5. Contrôleur de continuité de conducteurs de protection et de liaisons équipotentielles d'installations électriques selon l'une des revendications 1 à 4, **caractérisé en ce que** les formes du boitier (1) sont galbées et sans angle.

6. Contrôleur de continuité de conducteurs de protection et de liaisons équipotentielles d'installations électriques selon l'une de revendications 1 à 5, **caractérisé en ce qu'**il comprend au moins une autre connectique (7, 8) pour contrôler la continuité sur un appareil déconnecté du réseau.

7. Contrôleur de continuité de conducteurs de protection et de liaisons équipotentielles d'installations électriques selon l'une de revendications 1 à 6, **caractérisé en ce que** ledit boitier (1) d'électronique de test comprend un pont en H (26) pour assurer l'inversion automatique de polarité desdites connectiques.

8. Contrôleur de continuité de conducteurs de protection et de liaisons équipotentielles d'installations électriques selon l'une des revendications 1 à 7, **caractérisé en ce qu'**il comprend un système de compensation de la résistance du câble et des résistances de la carte.

9. Ensemble de test pour le contrôle de continuité de conducteurs de protection et de liaisons équipotentielles d'installations électriques, **caractérisé en ce qu'**il comporte :
- un contrôleur selon l'une des revendications précédentes,
- un câble (3) se terminant par un contact (4) apte à être connecté à une référence de terre du bâtiment ou logement, ledit câble étant raccordé au dispositif de test et étant enroulé sur le dérouleur (2) de celui-ci ou destiné à l'être,
- un cordon testeur (10, 11) qui est adapté pour être rapporté sur la connectique (7, 8) de l'électronique de test.

10. Utilisation d'un ensemble de test selon la revendication 9 pour le diagnostic d'un bâtiment ou d'un logement.

## Patentansprüche

1. Durchgangsprüfer von Schutzleitern und Potentialausgleichen elektrischer Installationen, einen Testelektronik-Kasten (1) beinhaltend, der eine Testelektronik umfasst, wobei der Kasten imstande ist, elektrisch mit einem Kabel (3) verbunden zu werden, das durch einen Kontakt (4) abgeschlossen wird, der imstande ist, an eine Spannungsreferenz angeschlossen zu werden, wobei der Kasten eine Schnittstellenfassade (5) für seine Steuerung und die Information des Nutzers umfasst, wobei der Prüfer eine Abrollvorrichtung (2) für das Kabel beinhaltet,
**dadurch gekennzeichnet, dass** der Testelektronik-Kasten und die Abrollvorrichtung aneinander befestigt sind, wobei die Abrollvorrichtung drehbar auf dem Kasten montiert ist und dadurch, dass die Testelektronik mindestens einen Steckverbinder (7, 8) für den Anschluss einer Tester-Leitung (10, 11) beinhaltet.

2. Durchgangsprüfer von Schutzleitern und Potentialausgleichen elektrischer Installationen nach Anspruch 1, **dadurch gekennzeichnet, dass** die Abrollvorrichtung (2) einen Steckverbinder mit Drehkontakt (12) beinhaltet, der imstande ist, das Kabel der Abrollvorrichtung und einen im Verhältnis zum Kasten (1) feststehenden axialen Kontakt zu verkabeln.

3. Durchgangsprüfer von Schutzleitern und Potentialausgleichen elektrischer Installationen nach Anspruch 2, **dadurch gekennzeichnet, dass** der Steckverbinder mit Drehkontakt eine Steckvorrichtung mit Bananensteckern mit Federlamellen ist.

4. Durchgangsprüfer von Schutzleitern und Potentialausgleichen elektrischer Installationen nach einem der Ansprüche 1 bis 3, **dadurch gekennzeichnet, dass** der Kasten (1) mindestens eine Führung (9) für seine ausgerichtete Fixierung am Gürtel eines Nutzers beinhaltet.

5. Durchgangsprüfer von Schutzleitern und Potentialausgleichen elektrischer Installationen nach einem der Ansprüche 1 bis 4, **dadurch gekennzeichnet, dass** die Formen des Kastens (1) geschwungen und ohne Winkel sind.

6. Durchgangsprüfer von Schutzleitern und Potentialausgleichen elektrischer Installationen nach einem der Ansprüche 1 bis 5, **dadurch gekennzeichnet, dass** er mindestens einen anderen Steckverbinder (7, 8) zum Prüfen des Durchgangs an einem vom Netz getrennten Apparat umfasst.

7. Durchgangsprüfer von Schutzleitern und Potentialausgleichen elektrischer Installationen nach einem der Ansprüche 1 bis 6, **dadurch gekennzeichnet, dass** der Kasten (1) mit Testelektronik eine H-Brücke (26) umfasst, um für die automatische Umkehr der Polarität der Steckverbinder zu sorgen.

8. Durchgangsprüfer von Schutzleitern und Potentialausgleichen elektrischer Installationen nach einem der Ansprüche 1 bis 7, **dadurch gekennzeichnet, dass** er ein System zum Kompensieren des Widerstandes des Kabels und der Widerstände der Karte umfasst.

9. Testeinheit für die Durchgangsprüfung von Schutzleitern und Potentialausgleichen elektrischer Installationen, **dadurch gekennzeichnet, dass** sie beinhaltet:
- einen Prüfer nach einem der vorstehenden Ansprüche,
- ein Kabel (3), das durch einen Kontakt (4) abgeschlossen wird, der imstande ist, an eine Erdreferenz des Gebäudes oder der Wohnung angeschlossen zu werden, wobei das Kabel an die Testeinrichtung angeschlossen ist und auf der Abrollvorrichtung (2) desselben aufgerollt ist, oder dies zu sein bestimmt ist,
- eine Tester-Leitung (10, 11), die angepasst ist, um auf dem Steckverbinder (7, 8) der Testelektronik befestigt zu werden.

10. Verwendung einer Testeinheit nach Anspruch 9, für die Diagnose eines Gebäudes oder einer Wohnung.

## Claims

1. Continuity tester for protective conductors and equipotential bondings of electrical installations, comprising an electronic tester casing (1) including an electronic tester, said casing being suitable for being electrically connected to a cable (3) ending in a contact (4) suitable for being connected to a voltage reference, said casing including an interface panel (5) for the control thereof and for providing information to the user, said tester comprising a reel (2) for unwinding said cable, **characterised in that** the electronic tester casing and the reel are attached to one another, the reel being mounted such that it rotates on said casing and
**in that** the electronic tester comprises at least one connector (7, 8) for connecting a test lead (10, 11).

2. Continuity tester for protective conductors and equipotential bondings of electrical installations according to claim 1, **characterised in that** the reel (2) comprises a rotary contact connector (12) suitable for connecting said cable of said reel with an axial contact that is fixed relative to the casing (1).

3. Continuity tester for protective conductors and equipotential bondings of electrical installations according to claim 2, **characterised in that** said rotary contact connector is a spring leaf banana plug connector.

4. Continuity tester for protective conductors and equipotential bondings of electrical installations according to one of claims 1 to 3, **characterised in that** said casing (1) comprises at least one guide (9) for the oriented fastening thereof to the belt of a user.

5. Continuity tester for protective conductors and equipotential bondings of electrical installations according to one of claims 1 to 4, **characterised in that** the shapes of the casing (1) are rounded and have no corners.

6. Continuity tester for protective conductors and equipotential bondings of electrical installations according to one of claims 1 to 5, **characterised in that** it comprises at least one other connector (7, 8) for testing the continuity on a device that is not connected to the network.

7. Continuity tester for protective conductors and equipotential bondings of electrical installations according to one of claims 1 to 6, **characterised in that** said electronic tester casing (1) comprises a H-bridge (26) to ensure the automatic polarity reversal of said connectors.

8. Continuity tester for protective conductors and equipotential bondings of electrical installations according to one of claims 1 to 7, **characterised in that** it comprises a system for compensating for the resistance of the cable and the resistances of the board.

9. Test assembly for testing the continuity of protective conductors and equipotential bondings of electrical installations, **characterised in that** it comprises:
- a tester according to one of the previous claims,
- a cable (3) ending in a contact (4) suitable for being connected to a ground reference of the building or accommodation, said cable being connected to the testing device and being wound on the reel (2) thereof or intended to be wound on the latter,
- a test lead (10, 11) suitable for being attached to the connector (7, 8) of the electronic tester.

10. Use of a test assembly according to claim 9 for performing diagnostics on a building or accommodation.
